Europäisches Patentamt

European Patent Office

Office européen des brevets

(11) Publication number: **0 073 938**
**B1**

(12) **EUROPEAN PATENT SPECIFICATION**

(45) Date of publication of patent specification: **24.07.85**

(21) Application number: **82107123.0**

(22) Date of filing: **06.08.82**

(51) Int. Cl.⁴: **C 30 B 11/14, C 30 B 29/60**

(54) **Production of semicrystalline silicon sheets.**

(30) Priority: **17.08.81 US 293129**

(43) Date of publication of application:
**16.03.83 Bulletin 83/11**

(45) Publication of the grant of the patent:
**24.07.85 Bulletin 85/30**

(84) Designated Contracting States:
**AT BE CH DE FR GB IT LI LU NL SE**

(56) References cited:
**DE-A-2 850 805**
**US-A-3 341 361**
**US-A-4 119 744**

(73) Proprietor: **Solarex Corporation**
**1335 Piccard Drive**
**Rockville Maryland 20850 (US)**

(72) Inventor: **Putney, Zimri C.**
**5102 Gunpowder Road**
**Fairfax Virginia (US)**
Inventor: **Regnault, William F.**
**18313 Queen Elizabeth Drive**
**Olney Maryland (US)**

(74) Representative: **Weber, Dieter, Dr. et al**
**Dr. Dieter Weber und Klaus Seiffert**
**Patentanwälte Gustav-Freytag-Strasse 25**
**Postfach 6145**
**D-6200 Wiesbaden 1 (DE)**

Courier Press, Leamington Spa, England.

## Description

This invention relates to a method of forming semicrystalline silicon sheets.

Until recent studies in photovoltaics have shown alternatives, solar energy cells, in which radiant energy from the sun is directly transduced into a flow of electrons, have employed single-crystal silicon as the basic material.

The cost of production of photovoltaic cells using single-crystal silicon is high.

Single-crystal silicon is produced by the Czochralski or the float zone methods. When the Czochralski method is used, molten silicon is seeded and the seeded silicon is then extended by a crystal pulling machine. In the float zone method, zones of a silicon ingot are melted by passing the ingot back and forth through a localized heater. In both processes the silicon is sliced and polished, and the substantial excess waste silicon returned to the melt for purification and crystallization.

Another method of producing single-crystal silicon is described in U.S. Patent No. 3,025,146 to Runyan. Runyan is directed to a method of growing shaped articles of a semiconductor material which, in the main, uses a seed crystal to initiate crystallization. The shaped article from the Runyan process is concave and requires cutting the crystallized silicon to remove it from the mold. Consequently, relatively large amounts of waste silicon material are created, and such silicon waste must be recycled.

It has recently been shown that for photovoltaic purposes, it is no longer necessary to utilize single-crystal silicon. A form of silicon called semicrystalline silicon, in which the silicon ingot or wafer is composed of many crystallites or grains of silicon, can be utilized as the host material for solar cells. The efficiency of a photovoltaic cell made from semicrystalline silicon can be as high as 17% (AM1), which is a very high efficiency for terrestrial photovoltaic uses. When the crystallographic order of the silicon is high within the large grains or crystallites, efficiencies can be achieved for solar cells formed from such semicrystalline silicon which, while they may not always be the equal of those made from monocrystalline silicon, do make the use of semicrystalline silicon highly cost-effective.

Accepting the fact that semicrystalline silicon can be a cost-effective host material, it then becomes expedient to develop processes for the formation of semicrystalline silicon in sheet form. One method that has been utilized in the past in an effort to form a ribbon or thin sheet of monocrystalline silicon directly from a molten bath has been one in which the molten silicon is drawn from a bath through a die. While this attempt has achieved some popularity, at least in terms of the hope that it may ultimately prove to be economically feasible, all such efforts have been met with the major difficulty of attempting to minimize interaction between the silicon and the materials forming the die. It will be appreciated that the temperature at which silicon is in a freely molten state is at or in excess of 1,410°C, the melting point of silicon. At and above such temperatures, silicon will react with most materials. Consequently, a die that can be used to form a silicon sheet of a particular shape must be made of a material that will neither react with nor form a eutectic composition with molten silicon.

The method of the present invention having the features specified in the appended claims permits the fabrication of semicrystalline sheet material, and preferably flat sheets of such material. Basically, a heated surface made from a material resistant to interaction with molten silicon is immersed in a bath of molten silicon until a thin layer of crystalline silicon solidifies on the surface. Then the surface is withdrawn from the bath with the layer intact, after which the layer is cooled and removed from the surface. The present process, unlike the prior art, does not require a seed of the material to initiate crystallization. The silicon sheet formed by this process requires little or no cutting and/or polishing prior to its use.

It is a prime object of the present invention to form thin sheets of silicon directly rather than first making an ingot and then slicing the ingot. It is further object of the invention that the silicon sheets formed by the method employed is far less expensive than comparable monocrystalline silicon sheets.

The process of our invention comprises the immersion of a silicon sheet forming surface into a container of molten silicon and then withdrawing the surface. As the surface is withdrawn, a thin layer of semicrystalline silicon is retained on the surface. After the surface is sufficiently cool, the silicon sheet is easily removed from the surface.

In an apparatus that may be utilized in carrying out the process of this invention, a block is suspended by a support rod, which may be equipped with thermocouples and/or heat exchange fluids to control the temperature of the block. The block, which is rectangular in horizontal cross-section, has a downwardly facing surface, formed from a material such as a ceramic or graphite. The silicon melt is contained with a nonreactive container. Means for heating and maintaining the required temperature in the container are known to those skilled in this art.

In the practice of this invention, the silicon melt is preferably maintaining at a temperature slightly above its melting point, that is, about 2°C to 10°C above the melting point of silicon, which is about 1410°C. The block, before contact with the silicon melt, is heated so that the temperature of the surface is less than the melt temperature. As the rate at which the sheet will form is largely a function of time and temperature, the closer the surface is to the melt temperature at the time of immersion, the longer it will take to form the sheet. The surface is heated to the range of about 950°C to about 1410°C, preferably about 1350° to 1410°C. If the temperature of the surface is less than about 950°C, the melt will solidify too rapidly, giving rise to a poorly structured silicon sheet. At a temperature above about 1410°C the silicon sheet may not form, or the formed silicon sheet may not cover the entire area of the surface.

Upon immersion of the surface into the melt, the temperature of the surface will normally increase. This is due to the higher temperature of the molten silicon. The surface is maintained in the bath until crystalline growth has been induced and initiated at the surface. The surface is then slowly withdrawn, preferably with rotation and with a layer of crystalline growth adhered thereto. If the so-formed silicon layer is in contact with the molten silicon for too long a period of time, the layer may remelt due to the heat of the melt. Also, variations in the time of withdrawal are possible, but preferably withdrawal will take place in less than about 60 seconds.

As the surface and solidified silicon layer formed thereon will contract at different rates when removed from the melt due to differences in their coefficients of thermal expansion, the surface may be selected to avoid cracking the silicon sheet as the sheet and surface cool. The surface must be substantially non-reactive with silicon, be capable of being separated from a cooled, semicrystalline sheet formed on the face thereof, and have heat absorbing properties. Although graphite is the preferred material, other materials such as silicon nitride, silicon carbide and ceramics may be employed. A graphite which has provided particularly good results has been graphite grade CMB, commercially available from Union Carbide Corporation, New York, New York.

The block will preferably be made from graphite in which the shape of the surface is the shape of the final silicon sheet desired, i.e. square, round, etc., and will be attached to a support rod or shaft to facilitate withdrawal from the molten silicon.

As the surface is withdrawn, a silicon layer is formed on the surface and a meniscus is formed by the bath at the interface with the block. The presence of a meniscus shows that the molten silicon has wetted the surface, whereby the layer will adhere to that surface. In addition, a positive meniscus facilitates heat rejection.

Silicon sheets formed by practice of the present invention will have a thickness of about 50 to 2000 microns, a mean grain size of at least about one millimeter and will have high crystallographic order within the grains with a minority carrier life of at least several microseconds.

A silicon sheet prepared according to the present invention used a surface of the lower part of a 1.5—1.75 square inch (9.68—11.29 cms) cross-section graphite block, graphite grade CMB, having a thickness of $2\frac{1}{2}$ inch (6.3 cm) attached to a support rod. The lower surface of the block has a machined face to provide relative smoothness. The face of the block was heated to about 1300°C and lowered into the molten silicon, which was at a temperature of 1415° to 1420°C maintained in a 3 inch (7.62 cm) diameter quartz crucible. The block was maintained in contact with the molten silicon for 30 to 40 seconds and then withdrawn over 15 to 20 seconds and allowed to cool. Upon the block's reaching ambient temperature, a square silicon sheet having the desired characteristics of crystal configuration, grain size and thickness was easily removed from the lower surface of the graphite block.

It will be appreciated that while the present invention has been described and illustrated with respect to a preferred embodiment thereof, certain obvious modifications, alterations and substitutions can be made thereto. It is intended that such modifications, alterations and substitutions fall within the purview of the present invention, which is defined only by the scope, including equivalents, of the following, appended claims.

## Claims

1. A method of forming a sheet of semicrystalline silicon suitable for use as a host material for photovoltaic cells, from a bath of molten silicon, comprising:

(a) providing a surface resistant to interaction with molten silicon,

(b) preheating said surface to a temperature of about 950° to 1410°C,

(c) immersing said heated surface in said bath of molten silicon,

(d) maintaining said surface in said bath for a period of time sufficient to induce crystalline growth at said surface,

(e) withdrawing said surface from said bath with a layer of said crystalline growth adhered thereto,

(f) cooling said surface and said layer of silicon crystalline growth adhered thereto, and

(g) separating said layer from said surface in the form of a silicon sheet.

2. A method as claimed in claim 1, in which said surface is formed from graphite.

3. A method as claimed in claim 1, in which said surface is part of a graphite block.

4. A method as claimed in claim 1, in which said surface is preheated to a temperature of about 1350° to 1410°C.

5. A method as claimed in claim 1, in which said bath is maintained at a temperature about 2°C to 10°C above the melting point of silicon.

6. A method as claimed in claim 1, in which said molten bath is maintained in a container, and said surface forms a meniscus of silicon with said molten bath.

7. A method as claimed in claim 6, in which said meniscus is positive.

8. A method as claimed in claim 1, in which said surface is withdrawn from said bath over a period of less than about 60 seconds.

9. A method as claimed in claim 1, in which said surface is rotated as it is withdrawn from said bath.

10. A method as claimed in claim 1, in which said surface is composed of a material selected from the group consisting of silicon carbide and silicon nitride.

## Patentansprüche

1. Verfahren zur Herstellung einer semikristallinen Siliciumplatte, die für die Verwendung als Grundmaterial für Fotozellen geeignet ist, aus einem Bad von geschmolzenem Silicium, wobei man

a) eine gegen Wechselwirkung mit geschmolzenem Silicium beständige Oberfläche vorsieht,

b) diese Oberfläche auf eine Temperatur von etwa 950° bis 1410°C vorerhitzt,

c) die erhitzte Oberfläche in das Bad von geschmolzenem Silicium eintaucht,

d) die Oberfläche in dem Bad ausreichend lange hält, um ein Kristallwachstum auf dieser Oberfläche einzuleiten,

e) die Oberfläche aus dem Bad mit einer daran anhaftenden Schicht dieses Kristallwachstums entfernt,

f) die Oberfläche und die daran anhaftende Schicht von Siliciumkristallwachstum abkühlt und

g) die Schicht von der Oberfläche in der Form einer Siliciumplatte abtrennt.

2. Verfahren nach Anspruch 1, bei dem die Oberfläche aus Graphit besteht.

3. Verfahren nach Anspruch 1, bei dem die Oberfläche Teil eines Graphitblockes ist.

4. Verfahren nach Anspruch 1, bei dem die Oberfläche auf eine Temperatur von etwa 1350° bis 1410°C erhitzt wird.

5. Verfahren nach Anspruch 1, bei dem das Bad auf eine Temperatur etwa 2°C bis 10°C oberhalb des Schmelzpunktes von Silicium gehalten wird.

6. Verfahren nach Anspruch 1, bei dem das geschmolzene Bad in einem Container gehalten wird und die Oberfläche mit diesem geschmolzenem Bad einen Siliciumminiskus bildet.

7. Verfahren nach Anspruch 6, bei dem der Miniskus positiv ist.

8. Verfahren nach Anspruch 1, bei dem die Oberfläche aus dem Bad während einer Zeit von weniger als etwa 60 Sekunden herausgenommen wird.

9. Verfahren nach Anspruch 1, bei dem die Oberfläche gedreht wird, wenn sie aus dem Bad herausgenommen wird.

10. Verfahren nach Anspruch 1, bei dem die Oberfläche aus einem Material aus der Gruppe Siliciumkarbid und Siliciumnitrid besteht.

## Revendications

1. Procédé de fabrication d'une plaque de silicium semicristalline pouvant être utilisée comme matériau porteur pour des cellules photovoltaïques, à partir d'un bain de silicium fondu, comprenant:

a) la prévision d'une surface résistant à l'interaction avec le silicium fondu,

b) la préchauffage de ladite surface jusqu'à une température comprise entre environ 950°C et 1410°C,

c) l'immersion de ladite surface chauffée dans ledit bain de silicium fondu,

d) le maintien de ladite surface dans ledit bain pendant une période de temps suffisante pour induire une croissance cristalline sur cette surface,

e) le retrait de cette surface dudit bain avec une couche desdits cristaux ayant pris naissance qui y adhère,

f) le refroidissement de ladite surface et de ladite couche de cristaux de silicium croissants qui y adhère, et

g) la séparation de ladite couche d'avec ladite surface sous la forme d'une plaque de silicium.

2. Procédé selon la revendication 1, dans lequel ladite surface est constituée en graphite.

3. Procédé selon la revendication 1, dans lequel ladite surface est constituée par une partie d'un bloc de graphite.

4. Procédé selon la revendication 1, dans lequel ladite surface est préchauffée jusqu'à une température comprise entre environ 1350°C et 1410°C.

5. Procédé selon la revendication 1, dans lequel ledit bain est maintenu à une température située entre environ 2°C à 10°C au-dessus du point de fusion du silicium.

6. Procédé selon la revendication 1, dans lequel ledit bain fondu est maintenu dans un récipient, et ladite surface forme un ménisque de silicium avec ledit bain fondu.

7. Procédé selon la revendication 6, dans lequel ledit ménisque est positif.

8. Procédé selon la revendication 1, dans lequel ladite surface est retirée dudit bain au cours d'une période inférieure à environ 60 secondes.

9. Procédé selon la revendication 1, dans lequel on fait tourner ladite surface lorsqu'on la retire dudit bain.

10. Procédé selon la revendication 1, dans lequel ladite surface est constituée d'un matériau choisi parmi le groupe comprenant le carbure de silicium et le nitrure de silicium.